## Europäisches Patentamt
## European Patent Office
## Office européen des brevets

(11) Veröffentlichungsnummer: **0 162 147**
**B1**

(12)

# EUROPÄISCHE PATENTSCHRIFT

(45) Veröffentlichungstag der Patentschrift:
**23.11.88**

(21) Anmeldenummer: **84115748.0**

(22) Anmeldetag: **18.12.84**

(51) Int. Cl.⁴: **H 03 H 1/00**

(54) **Filter-Baugruppe für Nachrichten- und Steuerleitungen, die zur Einführung in geschirmte Kabinen und Räume bestimmt sind.**

(30) Priorität: **19.04.84 DE 3414959**

(43) Veröffentlichungstag der Anmeldung:
**27.11.85 Patentblatt 85/48**

(45) Bekanntmachung des Hinweises auf die Patenterteilung:
**23.11.88 Patentblatt 88/47**

(84) Benannte Vertragsstaaten:
**BE CH DE FR GB IT LI NL**

(56) Entgegenhaltungen:
**EP-A-0 025 195**

(73) Patentinhaber: **Siemens Aktiengesellschaft Berlin und München, Wittelsbacherplatz 2, D-8000 München 2 (DE)**

(72) Erfinder: **Sammet, Wolfgang, Dipl.- Ing., Schlesierstrasse 25, D-8400 Regensburg (DE)**
Erfinder: **Dirmeyer, Josef, Dipl.- Ing.(FH), Neuenschwand 64, D-8465 Bodenwöhr (DE)**

## Beschreibung

Die Erfindung betrifft eine Filterbaugruppe für EMP-geschützte und ggf. entstörte Nachrichten- und Steuerleitungen, die zur Einführung in geschirmte Kabinen und Räume bestimmt sind.

Der zunehmende Einsatz hochempfindlicher Nachrichten- und Meßgeräte für hohe und höchste Frequenzen bedingt in steigendem Maße die Abschirmung von Räumen gegen elektromagnetische Felder. Ihre besondere Bedeutung erhält diese Schirmung noch zusätzlich durch den immer mehr zunehmenden Einsatz von industriellen HF-Generatoren, mechanischen Hochspannungsgleichrichtern, elektromedizinischen Geräten und ähnlichen Einrichtungen mit teilweise erheblicher Störstrahlenergie. Je nach den vorliegenden Verhältnissen handelt es sich entweder darum, Räume, in denen empfindliche Messungen durchgeführt oder in die Nachrichten- und Steuersignale störungsfrei eingeleitet werden, gegen von außen kommende Störfelder wirksam abzuschirmen oder aber störende Anlagen und Apparate in einem geschirmten Raum so unterzubringen, daß ihre Umgebung nicht gestört wird. Zur Lösung dieser Probleme wurden daher bereits geschirmte Kabinen und Raumabschirmungen mit Schirmungselementen für hohe Anforderungen geschaffen. Insbesondere gelangen hier Metallfolien bzw. Bleche zum Einsatz, die als Wand, Boden und Deckenelemente hochfrequenzdicht miteinander verbunden, insbesondere verschweißt sind. Bei Verwendung dieser Folien bzw. Bleche in geeigneter Materialstärke läßt sich eine beliebig hohe Schirmdämpfung der elektrischen und magnetischen Störkomponente erzielen, vorausgesetzt, die erforderlichen Fenster- und Türkonstruktionen für die geschirmten Kabinen und Räume besitzen die notwendige hochfrequenzdichte Abdichtung ihrer Spalten und Fugen.

Die in die geschirmten Kabinen und Räume führenden elektrischen Leitungen müssen hochfrequent verriegelt werden, um die hohen Dämpfungseigenschaften der Folien undstigen Schirmungselemente voll auszunutzen. Da die Dämpfung eines geschirmten Raumes durch das schwächste Glied mitbestimmt wird, kommt dieser Netzverriegelung eine besondere Bedeutung zu. Es wurden daher hochwertige HF-Entstörgeräte in Breitbandausführung entwickelt, die eine wirksame Entstörung bis zu 35 GHz sicherstellen.

Für die störungsfreie Einführung von Nachrichten - und Steuerleitungen in geschirmte Kabinen und Räume stehen Filter zur Verfügung, die aus Einzeldrosseln aufgebaut bzw. mit stromkompensierten Drosseln bestückt sind. Unter der Bezeichnung Filterreihe B 84 311 - .... im Handel erhältliche Siemens-Zweileiterfilter erfordern pro zu beschaltende Doppelader ein vollständiges, in einem vollgeschirmten Gehäuse untergebrachtes Filter, das wahlweise mit einem Vorsatzgerät für den EMP-Schutz, d. h. für den Überspannungsschutz ausrüstbar ist. Hierzu ist zu bemerken, daß der EMP-Schutz in all den Fällen erforderlich ist, in denen elektrische und elektronische Geräte und Anlagen durch nukleare elektromagnetische Impulse bedroht sind, die bekanntlich Feldgrößen im kV/m - und Amper/m-Bereich und Impulsanstiegs- bzw. Abfallzeiten von wenigen ns bzw. einigen 100 ns besitzen.

In all diesen Fällen, in denen mit impulsförmigen Überspannungen auf Leitungen zu rechnen ist, deren Amplitude die Stoßspannungsfestigkeit der eingesetzten Bauelemente übersteigt, sei es durch atmosphärische Entladungen, Schalthandlungen oder durch einen nuklearen elektromagnetischen Impuls (NEMP), kommen Entstörfilter mit integriertem Überspannungsschutz zur Anwendung. Hierfür geeignete elektrische Bauelemente sind z. B. Varistoren, Einzelableiter und Elektrodenableiter.

Beim vorstehend erwähnten Aufbau der bekannten, mit einem EMP-Vorsatz ausrüstbaren Filter ist es aufgrund der im Filtergehäuse angeordneten Durchführungskondensatoren nicht möglich, bei Zusammenfassung mehrerer Filter in einem geschirmten Schrank auf das in diesem Falle an sich unnötige Schirmgehäuse je Einzelfilter zu verzichten. Zusätzlich sind bei Einsatz dieser bekannten Filter in geschirmten Schränken auf der Schrankein- und Ausgangsseite Anschlußleisten für den Kunden notwendig, die über Kabelbäume sehr aufwendig mit den Filtern verbunden werden müssen. Da der EMP-Schutz nur gegeben ist, wenn der hierzu erforderliche EMP-Vorsatz in Kombination mit einem Entstörfilter betrieben wird, stand bisher auch für Fälle, in denen keine hohen Dämpfungsforderungen, sondern nur ein EMP-Schutz gefordert wurde, ausschließlich die Kombination eines EMP-Vorsatzgerätes mit einem 100 dB Filter zur Verfügung.

Ausgehend von den vorstehend aufgezeigten Problemen, liegt der Erfindung die Aufgabe zugrunde, eine für die Beschaltung einer größeren Anzahl von Nachrichten- und Steuerleitungen zum Zwecke des EMP-Schutzes und ggf. der Entstörung geeignete Filterbaugruppe mit einer für den reinen EMP-Schutz ausreichenden, geringeren Einfügungsdämpfung zu schaffen, die sowohl als Einzelbaugruppe mit eigenem Schirmgehäuse und entsprechenden Befestigungsmitteln für die geschirmten Kabinen und Räume verwendbar ist, als auch unter Verzicht auf ein eigenes Schirmgehäuse mit weiteren Filterbaugruppen in einem geschirmten Schrank zu einer Filtereinheit mit großer Zahl von Doppeladlern, d. h. mit hoher Packungsdichte, zusammengefaßt werden kann. Der mechanische Aufbau dieser Filter-Baugruppen soll dabei so gewählt sein, daß sich ohne erheblichen Mehraufwand eine Vielzahl von Schaltungsvariationen, z. B. betreffend eine höhere Dämpfung, anders dimensionierte Überspannungsableiter, Feinschutz und dergleichen, durchführen läßt.

Eine Filter-Baugruppe gemäß dem Oberbegriff des Patentanspruchs 1, welche diese Aufgabe löst, zeichnet sich erfindungsgemäß durch eine doppelseitig durchkontaktierte erste Leiterplatte als Träger der elektrischen Filterbauelemente aus, die - betrachtet in Filterdurchlaßrichtung - filtereingangsseitig eine zur Leiterplatte parallele Eingangsanschlußleiste trägt, und filterausgangsseitig an einen Flansch angeflanscht ist, durch den Filterdurchführungselemente zu einer auf dem Flansch befestigten zweiten Leiterplatte geführt sind, die auf ihrer zum Flansch abgekehrten Seite eine zur ersten Leiterplatte parallele Ausgangsanschlußleiste trägt.

Als Eingangsanschlußleiste dient dabei eine an sich bekannte, unter der Typenbezeichnung C 39 104 - A 77 - A 2 von Siemens vertriebene, mit durchlaufendem Masseleiter ausgerüstete, lötfreie Rangierleiste, die je Doppelader zwei Schneidklemmkontakte mit zwischengeschalteten Federkontakten aufweist, die zur Aufnahme von Überspannungsschutz-Elementen, insbesondere Knopf-Varistoren, Einzel- oder 3-Elektrodenableitern mittels Klemmsitz geeignet sind. Die verwendete Rangierleiste unterscheidet sich von der vorstehend genannten bekannten Rangierleiste nur durch das Fehlen des rückwärtigen Leistenteils, der durch eine einfache Isolierleiste mit Durchbrechungen für die zur Leiterplatte geführten Kontaktelemente ersetzt ist. Diese Rangierleiste stellt eine sehr induktivitätsarme Kontaktierung der Schutzelemente sicher. Ihre geringfügige Abänderung schafft darüberhinaus die Möglichkeit, die Rangierleiste so in Bezug auf die Leiterplatte auszurichten, daß die Schneidklemmkontakte und die in die Federkontakte der Rangierleiste eingeklemmten Überspannungsschutz-Elemente auch im eingebauten Zustand der Filter-Baugruppe frei zugänglich und damit ohne Demontage der Filter-Baugruppe und der Verkabelung mühelos auswechselbar sind.

Bevorzugt ist die erste Leiterplatte an Winkelelementen parallel geführter Bügel befestigt, deren Enden mit dem Flansch bzw. mit der Eingangsanschlußleiste verbunden sind. Ist dabei die erste Leiterplatte mit einem gemeinsamen, großflächigen Masseanschluß für die Filterbauelemente, z. B. Varistoren, belegt, der über die Winkelelemente und ihre Bügel mit dem Masseleiter der Eingangsanschlußleiste und dem Flansch kontaktiert ist, so ist damit die Gewähr für die Ableitung hoher Störströme zum Flansch und damit zur Schirmwand z. B. einer geschirmten Kabine geschaffen.

Das aufgezeigte Aufbauprinzip für eine Filter-Baugruppe ist auch anwendbar auf Filter-Baugruppen mit z. B. höheren Dämpfungswerten, Feinschutz durch Zener-Diode, Suppressor-Diode usw.

Diese Filter-Baugruppe ist z. B. mit einer Vielzahl gleicher Filter-Baugruppen in geschirmte Schränke, sog. Filterschränke einsetzbar, deren Aufgabe die EMP-geschützte und ggf. entstörte Einführung von Nachrichten und Steuerleitungen in geschirmte Räume und Kabinen ist. Diese Filter-Baugruppe kann aber auch als einzelne Filter-Baugruppe eingesetzt werden. In diesem Fall ist sie in einem Filtergehäuse untergebracht, das durch eine durchbrochene Trennwand in mit Kabelein- bzw. Auslässen ausgestaltete Filterein- bzw. Ausgangsseiten aufgeteilt ist, die - betrachtet in Filtereinschubrichtung - durch zumindest ausgangsseitig HF-dichte Deckel verschließbar sind. Das Filtergehäuse ist dabei mit seinem Kabelauslaß mit einer Schirmwand einer geschirmten Kabine bzw. eines geschirmten Raumes verbunden, insbesondere verschraubt.

Die Erfindung wird nachstehend anhand von Ausführungsbeispielen näher erläutert. Es zeigt:

Fig. 1 ein Ausführungsbeispiel einer Filter-Baugruppe nach der Erfindung in teilweise gebrochener und geschnittener Seitenansicht,

Fig. 2 in der Darstellung nach Fig. 1 eine Draufsicht auf die Filter-Baugruppe nach Fig. 1, wobei zur Veranschaulichung Teile der Baugruppe entfernt sind,

Fig. 3 eine Seitenansicht der Filter-Baugruppe nach Fig. 1, betrachtet in Pfeilrichtung gemäß Fig. 1,

Fig. 4 eine an eine Schirmwand einer geschirmten Kabine angeschraubte, in ein Filtergehäuse eingesetzte Filter-Baugruppe nach Fig. 1 in geschnittener und teilweise gebrochener Darstellung,

Fig. 5 ein Beispiel für eine Beschaltung einer EMP-geschützten Nachrichten- bzw. Steuerleitung für eine Filter-Baugruppe gemäß Fig. 1 bis 4.

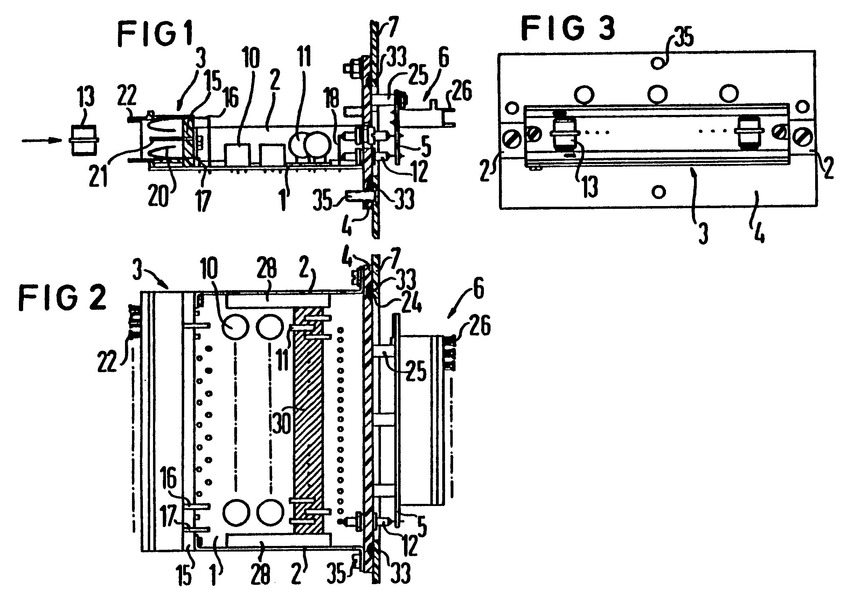

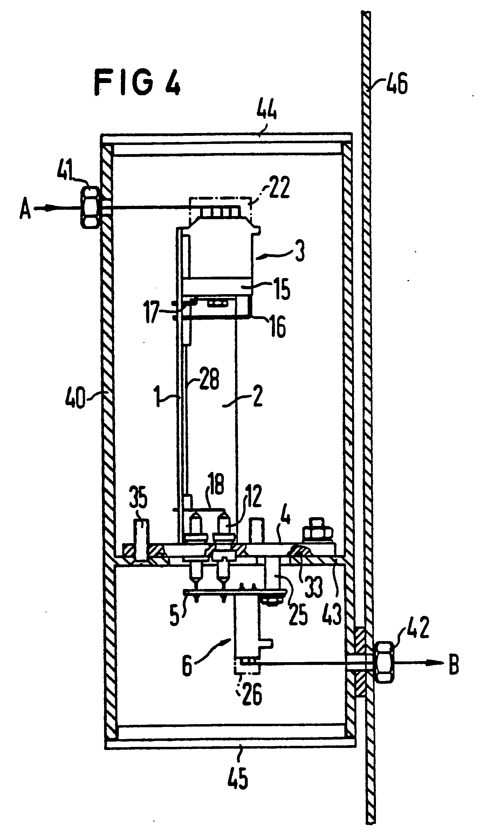

Die Filter-Baugruppe nach Fig. 1 bis 4 besitzt eine doppelseitig durchkontaktierte erste Leiterplatte 1 als Träger elektrischer Drosseln 10 und Varistoren 11, die z. B. gemäß dem Schaltbild nach Fig. 4 geschaltet sind Betrachtet in Filterdurchlaßrichtung ist filtereingangsseitig eine zur Leiterplatte 1 parallele Eingangsanschlußleiste 3 angeordnet, die eine mit Durchbrechungen für die Kontaktelemente 16, 17 ausgestattete Isolierleiste 15 aufweist. Diese an sich bekannte, in ihrem rückwärtigen Teil lediglich durch diese Leiste 15 ersetzte Rangier- bzu. Eingangsanschlußleiste 3 ist mit einem durchlaufenden Masseleiter 21 und je anzuschließender Doppelader mit zwei Schneidklemmkontakten 22 mit zwischengeschalteten Federkontakten 20 ausgerüstet. Die Schneidklemmkontakte 22 ermöglichen eine lötfreie Kontaktierung der Leitungen mit der Eingangsanschlußleiste 3. Die Federkontakte 20 hinwiederum gestatten die lötfreie Schaltung von Überspannungsschutz-Elementen, insbesondere Knopfvaristoren, Einzel- oder 3-Elektrodenableitern 13 zwischen die Schneidklemmkontakte 22.

Die Leiterplatte 1 ist mit ihrem von der Eingangsanschlußleiste 3 abgekehrten Ende an einen Metallflansch 4 angeflanscht, durch den Filterdurchführungselemente 12, z. B. Durchführungskondensatoren oder Durchführungsfilter zu einer mittels Abstandshaltern 25 am Flansch 4 befestigten zweiten Leiterplatte 5 geführt sind. Die Filterdurchführungselemente 12 sind mit ihren einen Enden mittels Kontaktelementen 18 mit den entsprechenden Leiterbahnen der ersten Leiterplatte 1 kontaktiert.

Die Leiterplatte 1 ist an Winkelelementen 28 parallel geführter Bügel 2 befestigt, deren Enden mit dem Flansch 4 bzw. mit der Eingangsanschlußleiste 3 verbunden sind. Die Leiterplatte 1 ist dabei mit einem gemeinsamen, großflächigen, d. h. breitbandigen Masseanschluß 30 für die Varistoren 11 belegt, der über die Winkelelemente 28 und ihre Bügel 2 mit dem Masseleiter 21 der Eingangsanschlußleiste 3 und dem Flansch 4 kontaktiert ist. Dieserart wird die Möglichkeit zur Ableitung hoher Störströme zum Flansch 4 und damit z. B. zu einer Schirmwand 7 einer nicht dargestellten geschirmten Kabine geschaffen.

Der Flansch 4 ist mit Bohrungen 35 versehen, durch die mittels Schraubverbindungen die Filter-Baugruppe an die Schirmwand 7 angeflanscht werden kann. Auf seiner zur Schirmwand 7 gekehrten Seitenfläche ist in entsprechende Nuten des Flansches 4 eine HF-Dichtungsschnur 33 eingelegt, die eine HF-dichte Verbindung des Flansches 4 mit der Schirmwand 7 gewährleistet.

An die zweite Leiterplatte 5, die mit ihren Abstandshaltern 25 und den Filterdurchführungselementen 12 durch die Ausnehmung 24 der Schirmwand 7 HF-dicht geführt ist, ist auf der vom Flansch 4 abgekehrten Seite eine Ausgangsanschlußleiste 6 befestigt. Diese Leiste ist gleichfalls eine an sich bekannte lötfreie Anschlußleiste, die je Doppelader zwei Schneidklemmkontakte 26 besitzt.

Fig. 4 zeigt eine einzelne Filter-Baugruppe nach Fig. 1 bis 3, die in ein Filtergehäuse 40 eingesetzt ist, das durch eine durchbrochene Trennwand 43 in mit Kabelein- bzw. auslässen A bzw. B ausgestattete Filterein- bzw. ausgangsseiten aufgeteilt ist. Die Durchführung der Kabel in das Gehäuseinnere bzw. vom Gehäuseinneren in einen durch die Schirmwand 46 aungedeuteten geschirmten Raum erfolgt z. B. dabei mittels einer Kabelverschraubung 41 bzw. einer HFdichten Schneidschraube 42. Das Filtergehäuse 40 ist - betrachtet in Filtereinschubrichtung - durch zumindest ausgangsseitig HF-dichte Deckel 44, 45 verschließbar.

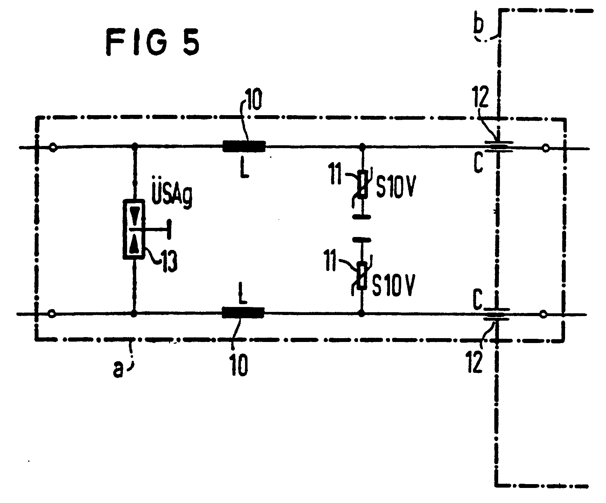

Ein Beispiel für eine geeignete, bekannte Schaltung für eine Filterbaugruppe für EMP-geschützte Nachrichten und Steuerleitungen zeigt Fig. 5. Die lediglich für eine Doppelader dargestellte Schaltung ist eine reine EMP-Schutzschaltung mit minimaler Einfügungsdämpfung. Als Überspannungsschutzelement ist ein 3-Elektrodenableiter 13 vorgesehen, Varistoren 11, Durchführungskondensatoren 12 und Induktivitäten 10, die z. B. Filterspulen mit RM-Ferrit-Kernen sind, ergänzen die Schaltung. Mit strichlinierten Linien a bzw. b sind hier das Filtergehäuse und die Schirmwand einer nicht dargestellten, geschirmten Kabine angedeutet. Die vorstehende Schaltung ist - wie bereits erwähnt lediglich ein Ausführungsbeispiel für eine mögliche Schaltung. Es sind auch Schaltungen denkbar, die sich durch höhere Dämpfungswerte, durch Feinschutz mittels Zener-Diode, Suppressor-Diode und dergleichen auszeichnen.

**Patentansprüche**

1. Filter-Baugruppe für EMP-geschützte und ggf. entstörte Nachrichten- und Steuerleitungen, die zur Einführung in geschirmte Kabinen und Räume bestimmt sind, gekennzeichnet durch eine doppelseitig durchkontaktierte erste Leiterplatte (1) als Träger der elektrischen Filter-Bauelemente (10, 11) die - betrachtet in Filterdurchlaßrichtung - filtereingangsseitig eine zur Leiterplatte parallele Eingangsanschlußleiste (3) trägt, und filterausgangsseitig an einen Flansch (4) angeflanscht ist, durch den Filterdurchführungselemente (12) zu einer auf dem Flansch befestigten zweiten Leiterplatte (5) geführt sind, die auf ihrer zum Flansch abgekehrten Seite eine zur ersten Leiterplatte parallele Ausgangsanschlußleiste (6) trägt.

2. Filter-Baugruppe nach Anspruch 1, dadurch gekennzeichnet, daß die Eingangsanschlußleiste (3) eine an sich bekannte, mit durchlaufendem Masseleiter (21) ausgerüstete, lötfreie Rangierleiste ist, die je Doppelader zwei Schneidklemmkontakte (22) mit zwischengeschalteten Federkontakten (20) aufweist, die zur Aufnahme von Überspannungsschutz-Elementen, insbesondere Knopf-Varistoren, Einzel- oder 3-Elektrodenableitern (13) mittels Klemmsitz geeignet sind.

3. Filter-Baugruppe nach Anspruch 1, dadurch gekennzeichnet, daß die erste Leiterplatte (1) an Winkelelementen (28) parallel geführter Bügel (2) befestigt ist, deren Enden mit dem Flansch (4) bzw. mit der Eingangsanschlußleiste (3) verbunden sind.

4. Filter-Baugruppe nach Anspruch 1 bis 3, dadurch gekennzeichnet, daß die erste Leiterplatte (1) mit einem gemeinsamen, großflächigen Masseanschluß (30) für die Filterbauelemente (11) belegt ist, der über die Winkelelemente (28) und ihre Bügel (2) mit dem Masseleiter (21) der Eingangsanschlußleiste (3) und dem Flansch (4) kontaktiert ist.

5. Filter-Baugruppe nach Anspruch 1 bis 4, dadurch gekennzeichnet, daß der Flansch (4) zur Schraubverbindung (35) der Filterbaugruppe mit den Außenwänden (7) geschirmter Kabinen und Räume Bohrungen aufweist.

6. Filter-Baugruppe nach Anspruch 1 bis 5, dadurch gekennzeichnet, daß der Flansch (4) auf seiner zur zweiten Leiterplatte (6) gekehrten Seitenfläche eine HF-Dichtung, insbesondere HF-Dichtungsschnur (33) trägt.

7. Filter-Baugruppe nach Anspruch 1 bis 6, dadurch gekennzeichnet, daß die Ausgangsanschlußleiste (6) eine an sich bekannte lötfreie Anschlußleiste ist, die je Doppelader zwei Schneidklemmkontakte (26) aufweist.

8. Filter-Baugruppe nach Anspruch 1 bis 7, gekennzeichnet, durch ein Filtergehäuse (40), das durch eine durchbrochene Trennwand (43) in mit Kabelein- bzw. auslässen (41, 42) ausgestattete Filterein- bzw. ausgangsseiten aufgeteilt ist, die - betrachtet in Filtereinschubrichtung - durch zumindest ausgangsseitig hochfrequenzdichte Deckel (44, 45) verschließbar sind.

9. Filter-Baugruppe nach Anspruch 8, dadurch gekennzeichnet, daß die Filterbaugruppe an die Trennwand (43) angeflanscht ist.

10. Filter-Baugruppe nach Anspruch 8 und 9, dadurch gekennzeichnet, daß das Filtergehäuse (40) mit seinem Kabelauslaß (42) mit einer Schirmwand (46) einer geschirmten Kabine bzw. eines geschirmte Raumes verbunden, insbesondere verschraubt ist.

**Claims**

1. A filter assembly for EMP-protected communications and control lines, screened where appropriate, which are intended for insertion into shielded booths and rooms, characterised by a double-sided contacted first circuit board (1) which serves as carrier for the electrical filter components (10, 11), and which is provided, at the input end of the filter, considered in the filter-conducting direction, with an input terminal strip (3) which extends in parallel to the circuit board, and is attached to a flange (4) through which filter feed-through elements (12), at the output end of the filter, lead to a second circuit board (5) attached to the flange and bears, on its side remote from the flange, an output terminal strip (6) which extends parallel to the first circuit board.

2. A filter assembly as claimed in Claim 1, characterised in that the input terminal strip (3) is a solder-free jumper strip known per se which is equipped with a continuous earth conductor (21), and which, for each double wire, comprises two cutting/clamping contacts (22) with interposed spring contacts (20) that serve to accommodate excess voltage protection elements, in particular knob varistors, individual or three-electrode arresters (13), by a clamp fit.

3. A filter assembly as claimed in Claim 1, characterised in that the first circuit board (1) is attached to angle elements (28) of parallel-extending brackets (2), the ends of which are connected to the flange (1) and to the input terminal strip (3).

4. A filter assembly as claimed in Claims 1 to 3, characterised in that the first circuit board (1) is connected to a common, large-area earth terminal (30) for the filter components, which terminal is contacted via the angle elements (28) and their brackets (2) to the earth conductor (21) of the input terminal strip (3) and to the flange (4).

5. A filter assembly as claimed in Claims 1 to 4, characterised in that the flange (4) contains bores for the screw connection (35) of the filter assembly to the outer walls (7) of shielded booths and rooms.

6. A filter assembly as claimed in Claims 1 to 5, characterised in that, on its side surface which faces towards the second circuit board (6), the flange (4) is provided with a HF-seal, in particular a HF-sealing cord (33).

7. A filter assembly as claimed in Claims 1 to 6, characterised in that the output terminal strip (6) is a solder-free terminal strip known per se which comprises two cutting/clamping contacts (26) for each double wire.

8. A filter assembly as claimed in Claims 1 to 7, characterised by a filter housing (40) which is sub-divided by a perforated partition wall (43) into filter input and output sides which are equipped with cable inlets and outlets (41, 42), and which can be closed, considered in the filter insertion direction, by covers (41, 45) which are shielded from high frequencies at least at the output end.

9. A filter assembly as claimed in Claim 8, characterised in that the filter assembly is flange-attached to the partition wall (43).

10. A filter assembly as claimed in claims 8 and 9, characterised in that the filter housing is connected, in particular screwed, to a shielding wall (46) of a shielded booth or a shielded room by its cable outlet (42).

**Revendications**

1. Module formant filtre pour des lignes de transmission d'informations et des lignes de commande protégées contre des perturbations électromagnétiques et éventuellement antiparasitées, qui sont destinées à être introduites dans des cabines et des locaux blindés, caractérisé par une première plaquette à circuits imprimés (1) possédant des contacts traversants sur ses deux faces et constituant le support des composants électriques (10, 11) du filtre, qui - lorsque l'on considère la direction de transmission dans le filtre - porte, sur son côté entrée, une barrette de connexions d'entrée (3) parallèle à la plaquette a circuits imprimés, et est raccordé, par bride sur son côté sortie, à une bride (4) que traversent des éléments (12) de traverse du filtre reliés à une seconde plaquette à circuits imprimés (5) qui est fixée sur la bride et porte, sur sa face tournée à l'opposé de cette dernière, une barrette de connexions de sortie (6) parallèle à la première plaquette a circuits imprimés.

2. Module formant filtre suivant la revendication 1, caractérisé par le fait que la barrette de connexions d'entrée (3) est une barrette de raccordement sans soudure, connue en soi, qui est équipee d'un conducteur continu de masse (21) et comporte, pour chaque conducteur double, deux contacts à sectionnement d'isolant (22), entre lesquels sont intercalés des contacts élastiques (20), qui conviennent pour recevoir des éléments de protection contre les surtensions, notamment des varistances en forme de boutons des éléments (13) dérivant des surtensions à une électrode ou à 3 électrodes, selon un ajustement serré.

3. Module formant filtre suivant la revendication 1, caractérisé par le fait que la plaquette à circuits imprimés (1) est fixée sur des éléments de cornière (28) d'étriers parallèles (2), dont les extrémitês sont reliées à la bride (4) ou à la barrette de connexions d'entrée (3).

4. Module formant filtre suivant les revendications 1 à 3, caractérisé par le fait que la première plaquette à circuits imprimés (1) comporte par une borne de masse commune (30) possédant une surface étendue, prévue pour les composants (11) du filtre et pouvant être raccordée par l'intermédiaire des éléments de cornière (28) et de leurs étriers (2) au conducteur de masse (21) de la barrette de connexions d'entrée (3) et à la bride (4).

5. Module formant filtre suivant les revendications 1 à 4, caractérisé par le fait que la bride (4) comporte les perçages pour la fixation par vissage (35) du module formant filtre aux parois extérieures (7) de cabines et le locaux blindés.

6. Module formant filtre suivant les revendications 1 à 5, caractérisé par le fait que la bride (4) porte, sur sa surface latérale tournée vers la seconde plaquette à circuits imprimés (6), une garniture réalisant une étanchéité aux hautes fréquences, notamment un cordon d'étanchéité aux hautes fréquences (33).

7. Module formant filtre suivant les revendications 1 à 6, caractérisé par le fait que la barrette de connexions de sortie (6) est une barrette de raccordement sans soudure connue en soi, qui comporte, pour chaque conducteur double, deux contacts à sectionnement d'isolant (26).

8. Module formant filtre suivant les revendications 1 à 7, caractérisé par un boîtier de filtre (40), qui est subdivisé par une cloison de séparation interrompue (43) en des côtés entrée et sortie du filtre, qui sont équipés d'entrées et de sorties (41, 42) de câbles et peuvent être fermés - lorsque l'on considère la direction d'insertion du filtre - par des couvercles (44, 45) étanches à la haute fréquence, situés au moins sur le côté sortie.

9. Module formant filtre suivant la revendication 8, caractérisé par le fait que le module formant filtre est raccordé par brides à la cloison de séparation (43).

10. Module formant filtre suivant les revendications 8 et 9, caractérisé par le fait que le boîtier de filtre (40) est relié, notamment par vissage, par sa sortie de câbles (42), à une paroi de blindage (46) d'une cabine blindée ou d'un local blindé.

FIG 3

FIG 1

FIG 2

# FIG 4

# FIG 5